# EUROPEAN PATENT APPLICATION

(11) **EP 2 306 650 A2**
(43) Date of publication of application: **06.04.2011**
(21) Application number: 10011247.3
(22) Date of filing: 28.09.2010
(51) Int. Cl.: H03M 1/10, H03M 1/12

(54) **A/d converter and open detection method thereof**

(30) Priority: 30.09.2009 JP 2009227586
(71) Applicant: Renesas Electronics Corporation, Nakahara-ku Kawasaki Kanagawa 211-8668 (JP)
(72) Inventor: Ariyoshi, Satoshi, Kanwasaki Kanagawa 211-8668 (JP); Tsubota, Masashi, Kanwasaki Kanagawa 211-8668 (JP)
(74) Representative: Glawe, Delfs, Moll

(57) **Abstract**

An A/D converter includes a sampling capacitor that accumulates a charge according to an input voltage, a first initialization switch that initializes the sampling capacitor, a sample hold switch that switches a connection state of an external input terminal and the sampling capacitor, and a second initialization switch that initializes a charge accumulated in an input node via a resistor, the input node connecting the external input terminal and the sample hold switch.

## Description

This application is based upon and claims the benefit of priority from Japanese patent application No. 2009-227586, filed on September 30, 2009, the disclosure of which is incorporated herein in its entirety by reference.

### BACKGROUND

### 1. Field of the Invention

The present invention relates to an A/D converter and an open detection method thereof.

### 2. Description of Related Art

In a control device including a control circuit, such as a microcomputer, when reading an analog signal obtained from a sensor into the control circuit, the analog signal must be converted into a digital signal by an A/D converter. At this time, especially in a vehicle system or the like, failure of the sensor or the A/D converter greatly influences the operation. Therefore, it is necessary to take the measure for detecting the failure of the sensor and the A/D converter and guaranteeing the operation of the control device.

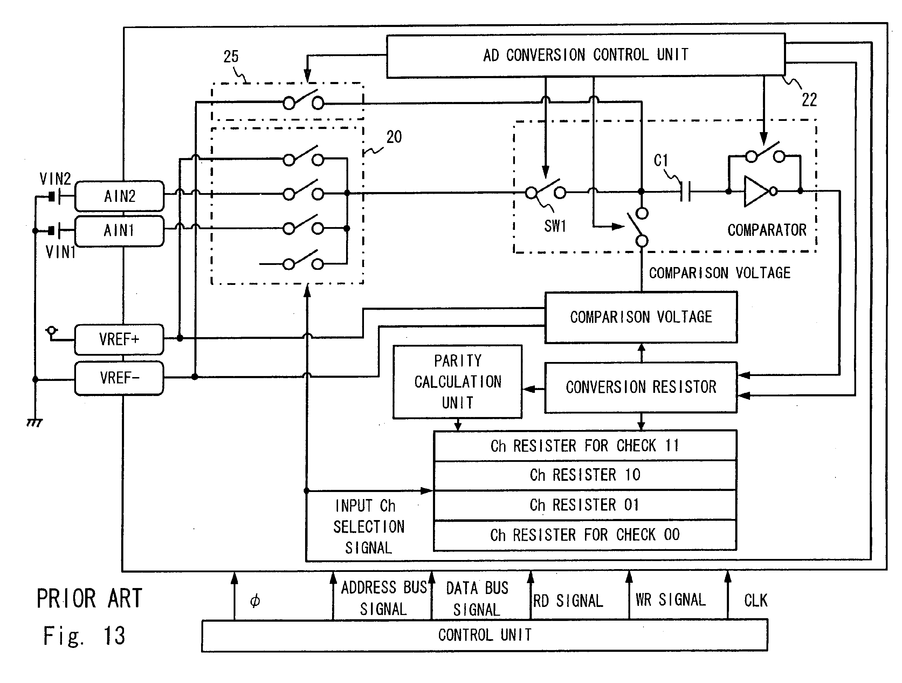

Fig. 13 is a block diagram of an A/D converter including an open detection circuit disclosed in Japanese Unexamined Patent Application Publication No. 2005-184118. In this example, the A/D converter includes an input Ch selection SW unit 20 that selectively specifies and outputs one of input signals from outside, an S/H capacitor C1 that accumulates charges corresponding to an input voltage, a switch SW1 that switches the connection state of an external input terminal and the S/H capacitor C1, an S/H capacitor initialization SW 25 that initializes the charges accumulated in the S/H capacitor C1, and an A/D converter control unit 22 that controls the operation of each functional block.

As shown in this example, the charge accumulated in the S/H capacitor C1 is initialized by the S/H capacitor initialization SW 25. Therefore, when there is an anomaly in the S/H capacitor C1 or a disconnection anomaly (input terminal opened) in the input system from the sensor, even if A/D conversion is performed after that, the charges are not accumulated in the S/H capacitor C1. Therefore, the charges accumulated in the S/H capacitor C1 at this time are still in the state in which the S/H capacitor C1 was initialized.

An analog voltage value of the initialized S/H capacitor C1 shall be a lower reference voltage (VREF-) of the reference voltage, i.e., a value equivalent to 0% of the reference voltage. Further, a failure evaluation value range (open detection voltage range) shall be a value equivalent to 10% or less than the reference voltage. At this time, if an anomaly such as a disconnection is generated between an analog signal source and the external input terminal or between the external input terminal and the S/H capacitor C1 in the A/D converter, as the S/H capacitor C1 remains in the initialized state, the anomaly is determined to be an anomaly in the input system. Accordingly, it is possible to detect a failure of the A/D converter by this configuration (the detection is hereinafter referred to as open detection).

### SUMMARY

However, in most of the cases in fact, a leakage current source such as a protection diode is included in the external input terminal for prevention from destroying the device. Therefore, also in the case of the input terminal opened, charges are accumulated in the parasitic capacitance by the leakage current flowing from the protection diode or the like. The present inventors have found a problem that this causes a potential of the initialized S/H capacitor to fluctuate, and thereby disabling to perform accurate open detection.

That is, in the open detector circuit of the A/D converter of the related art, there has been a problem that accurate open detection can not be performed by leakage current.

An exemplary aspect of the invention is an A/D converter that includes a sampling capacitor (for example, a sampling capacitor 104 in a first exemplary embodiment of the present invention) that accumulates a charge according to an input voltage, a first initialization switch (for example, an initialization switch 105 in the first exemplary embodiment of the present invention) that initializes the sampling capacitor, a sample hold switch (for example, a sample hold switch 106 in the first exemplary embodiment of the present invention) that switches a connection state of an external input terminal (for example, an external input terminal 107 in the first exemplary embodiment of the present invention) and the sampling capacitor, and a second initialization switch (for example, a parasitic capacitance initialization switch 108 in the first exemplary embodiment of the present invention) that initializes a charge accumulated in an input node via a resistor, the input node connecting the external input terminal and the sample hold switch.

By the above configuration, it is possible to initialize the charges accumulated by the leakage current source in the parasitic capacitance and achieve open detection with little influence of the leakage current.

Another exemplary aspect of the invention is an open detection method of an A/D converter including a sampling capacitor (for example, a sampling capacitor 104 in a first exemplary embodiment of the present invention) and a switch (for example, a sample hold switch 106 in the first exemplary embodiment of the present invention) connected between the sampling capacitor and an input terminal (for example, an external input terminal 107 in the first exemplary embodiment of the present invention), the open detection method including initializing a parasitic capacitance that is formed in wiring between the input terminal and the switch, after the initialization, connecting the sampling capacitor to the input terminal by the switch and sampling an input voltage, and detecting open failure according to a sampling result of the sampling capacitor.

By the above method, it is possible to initialize the charges accumulated by the leakage current source in the parasitic capacitance and achieve open detection with little influence of the leakage current.

The present invention provides an A/D converter capable of performing open detection with little influence of the leakage current.

### BRIEF DESCRIPTION OF THE DRAWINGS

The above and other aspects, features, and advantages of the present invention will become more apparent from the following description of certain exemplary embodiments when taken in conjunction with the accompanying drawings, in which:
Fig. 1 is a block diagram of an A/D converter according to a first and a second exemplary embodiments of the present invention;
Fig. 2 illustrates a circuit configuration of the A/D converter according to the first and the second exemplary embodiment of the present invention;
Fig. 3 illustrates a circuit configuration of the A/D converter according to other exemplary embodiments of the present invention;
Fig. 4 is a timing chart of the A/D converter according to the first exemplary embodiment of the present invention;
Fig. 5 is a timing chart of the A/D converter according to the first exemplary embodiment of the present invention;
Fig. 6 is a timing chart of the A/D converter according to a second exemplary embodiment of the present invention;
Fig. 7 is a timing chart of an A/D converter according to a third exemplary embodiment of the present invention;
Fig. 8 is a block diagram of an A/D converter according to a fourth exemplary embodiment of the present invention;
Fig. 9 is a timing chart of an A/D converter according to the other exemplary embodiments of the present invention;
Fig. 10 illustrates a circuit configuration of the A/D converter according to the other exemplary embodiments of the present invention;
Fig. 11 illustrates an A/D converter according to a related art;
Fig. 12 is a timing chart of the A/D converter according to the related art; and
Fig. 13 illustrates a circuit configuration of the A/D converter according to a related art.

### DETAILED DESCRIPTION OF THE EXEMPLARY EMBODIMENTS

Hereinafter, specific exemplary embodiments incorporating the present invention are described in detail with reference to the drawings. In each drawing, same components are denoted by the same numerals, and repeated explanation is omitted as necessary for the clarity of the explanation.

### [First exemplary embodiment]

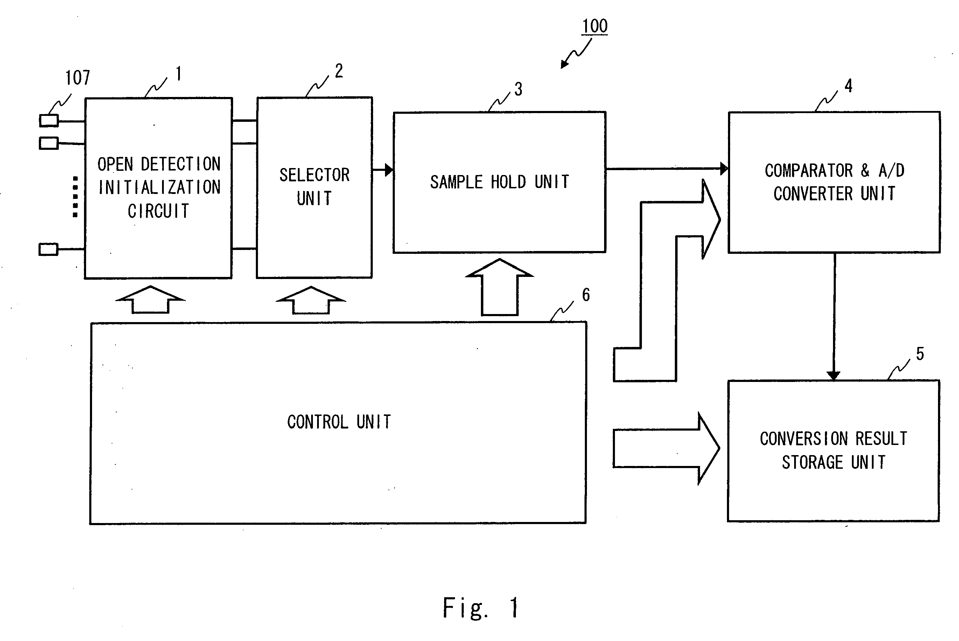

Hereinafter, exemplary embodiments of the present invention are described with reference to the drawings. Fig. 1 is a block diagram of an A/D converter 100 according to a first exemplary embodiment of the present invention. As shown in Fig. 1, the A/D converter 100 includes an open detection initialization circuit 1 that initializes charges accumulated in a parasitic capacitance, a selector unit 2 that selects one of input signals from outside, a sample hold unit 3 that accumulates charges according to the voltage of the input signal, a comparator and A/D converter unit 4 that performs A/D conversion process, a conversion result storage unit 5 that stores the converted digital data, and a control unit 6 that controls the process of each functional block.

Each of the open detection initialization circuit 1, the selector unit 2, the sample hold unit 3, the comparator and A/D converter unit 4, and the conversion result storage unit 5 are controlled by a control signal output from the control unit 6. External input terminals 107 are connected to respective input terminals of the selector unit 2 via the open detection initialization circuit 1. An output terminal of the selector unit 2 is connected to an input terminal of the sample hold unit 3. An output terminal of the sample hold unit 3 is connected to an input terminal of the comparator and A/D converter unit 4. An output terminal of the comparator and A/D converter unit 4 is connected to an input terminal of the conversion result storage unit 5.

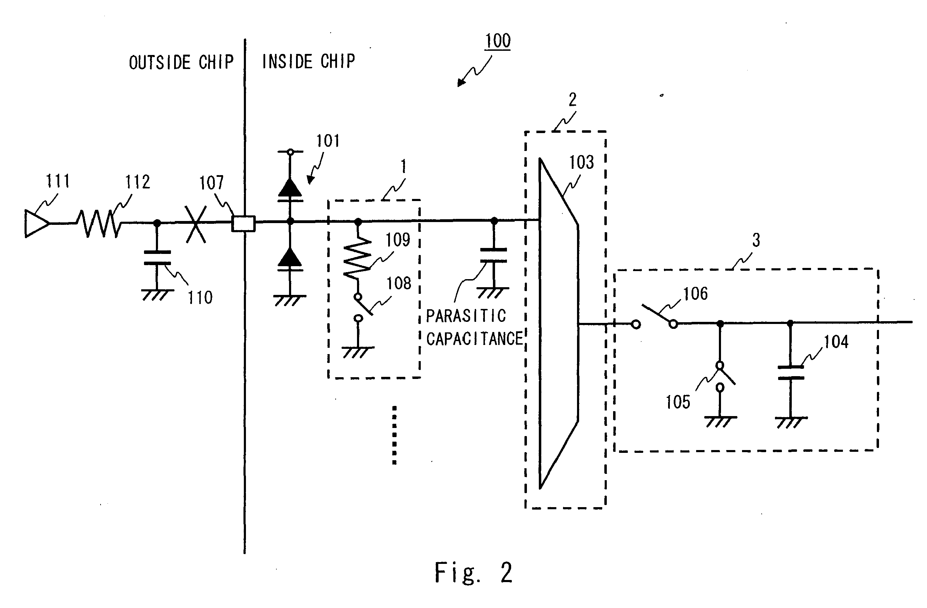

Each analog signal supplied by a voltage source 111 (Fig. 2) via a resistor 112 (Fig. 2) is input to the external input terminal 107 of the A/D converter 100. In the A/D converter 100, this analog signal is input to the selector unit 2 via the open detection initialization circuit 1. Then, among the signals input to the selector unit 2, the signal selectively specified according to the control signal output from the control unit 6 is output from the selector unit 2. The signal output from the selector unit 2 is input to the sample hold unit 3. The signal output from the sample hold unit 3 is input to the comparator and A/D converter unit 4. The comparator and A/D converter unit 4 compares the voltage level of the signal output from the sample hold unit 3 with a voltage level generated based on the reference voltage, and outputs digital data at the matched voltage level to the conversion result storage unit 5. Then, the conversion result storage unit 5 stores the digital data. By disposing the open detection initialization circuit 1 in the A/D converter 100, the charges accumulated in the parasitic capacitance can be initialized (discharged), thus it is possible to perform open detection with little influence of leakage current.

Next, Fig. 2 illustrates a detailed circuit configuration of the A/D converter 100 according to the first exemplary embodiment of the present invention. In the A/D converter 100, the open detection initialization circuit 1 includes a resistive element 109 and a parasitic capacitance initialization switch (second initialization switch) 108. The selector unit 2 includes a selector 103. The sample hold unit 3 includes a sampling capacitor 104, an initialization switch (first initialization switch) 105, and a sample hold switch 106. Further, the A/D converter 100 includes a protection diode 101 for the external input terminal 107.

In the example of the circuit shown in Fig. 2, only one external input terminal and the corresponding peripheral circuits are illustrated. However there are actually a plurality of (any integer of one or more) external input terminals 107 that are connected to corresponding input terminals of the selector 103. Each open detection initialization circuit 1 is disposed between each external input terminal 107 and the selector 103. Each open detection initialization circuit 1 includes the resistive element 109 and the parasitic capacitance initialization switch 108. Note that the resistive element 109 and the parasitic capacitance initialization switch 108 are connected in series between an input node, which connects the external input terminal 107 and the selector 103, and a ground voltage terminal. An output terminal of the selector 103 is connected to one terminal of the sample hold switch 106. The other terminal of the sample hold switch 106 is connected to one terminal of the initialization switch 105, and one terminal of the sampling capacitor 104, and the comparator and A/D converter unit 4 (see Fig. 1). The other terminal of the initialization switch 105 and the other terminal of the sampling capacitor 104 are connected to the ground voltage terminal.

Next, an operation of the circuit shown in Fig. 2 is explained. The analog signal supplied by the voltage source 111 via the resistor 112 is input to the external input terminal 107 of the A/D converter 100. This analog signal is input to the selector 103 in the A/D converter 100. Among the signals input to the selector 103, the signal selectively specified according to the control signal output from the control unit 6 is output from the selector 103.

An operation of the sample hold unit 3 is explained. The operation of the sample hold unit 3 is generally divided into initialization of the sampling capacitor 104, sampling, and hold and comparison. In the initialization of the sampling capacitor 104, firstly the sampling hold unit 3 turns off the connection state of the sample hold switch 106. Then, the sampling hold unit 3 turns on the connection state of the initialization switch 105 to initialize (discharge) the charges accumulated in the sampling capacitor 104. In the sampling, the sampling hold unit 3 turns off the connection state of the initialization switch 105, and also turns on the connection state of the sampling hold switch 106, in order to accumulate the charges according to the signal output from the selector 103 in the sampling capacitor 104. In the hold and comparison, the sampling hold unit 3 turns off the connection state of the sample hold switch 106 to stop supplying the charges to the sampling capacitor 104, and also outputs the charge accumulated in the sampling capacitor 104 to the comparator and A/D converter unit 4. Then, the comparator and A/D converter unit 4 performs A/D conversion according to the input signal output from the sample hold unit 3.

Next, open detection operation of the A/D converter 100 without consideration over the leakage current is described. As mentioned above, the charges accumulated in the sampling capacitor 104 are initialized (discharged) by the initialization switch 105. When there is an anomaly in the sampling capacitor 104 or a disconnection anomaly (input terminal opened) in the input system from the sensor, charges are not accumulated in the sampling capacitor 104 in the subsequent sampling operation. Therefore, the charges accumulated in the sampling capacitor 104 at this time remain to be the state when the sampling capacitor 104 is initialized.

A voltage value output from the initialized sampling capacitor 104 shall be a lower reference voltage (VREF-) of the reference voltage, i.e., a value equivalent to 0% of the reference voltage. Further, a voltage range to perform open detection (the range hereinafter referred to as an open detection voltage range) shall be a value equivalent to 10% or less than the reference voltage. At this time, if an anomaly such as a disconnection is generated between an analog signal source and the external input terminal 107 or between the external input terminal 107 and the sampling capacitor 104, as the sampling capacitor 104 remains in the initialized state (near 0 V) in the subsequent sampling operation, the anomaly is determined to be an anomaly in the input system. Therefore, it is possible to perform open detection of the A/D converter by this configuration.

However, as shown in Fig. 2, in most of the cases in fact, a leakage current source such as a protection diode 101 is included in the external input terminal 107 for prevention from destroying the device. By the influence of the leakage current flowing from the protection diode 101 or the like, even in the case of the input terminal opened, charges are accumulated in the parasitic capacitance of the selector 103 or the like in the sampling operation. Therefore, there has been a problem that the potential of the initialized sampling capacitor 104 fluctuates, and thereby disabling to perform accurate open detection. In order to solve such problem, the A/D converter 100 according to this exemplary embodiment includes the open detection initialization circuit 1.

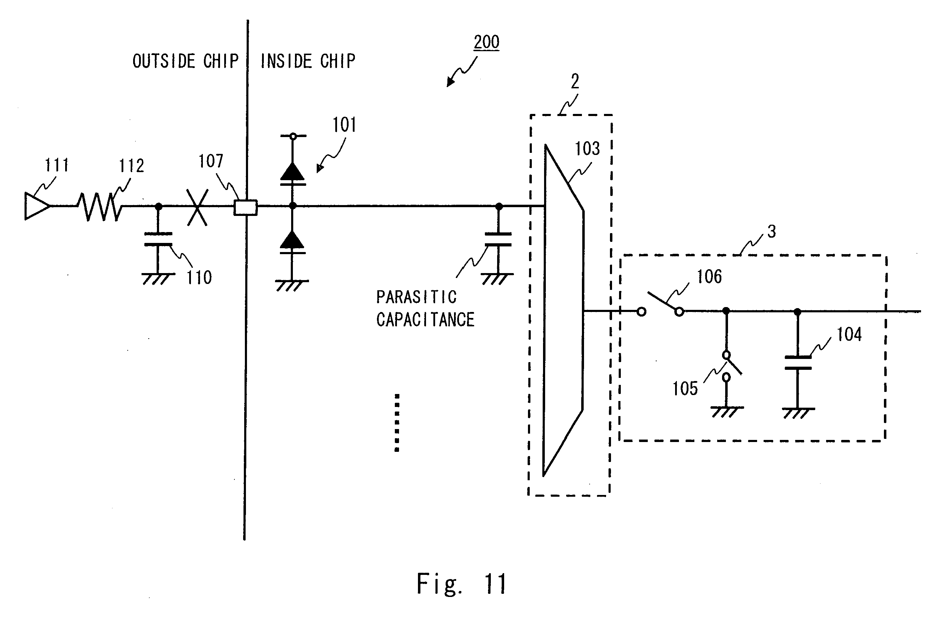

The open detection operation of the A/D converter 100 according this exemplary embodiment is explained. In order to compare the difference made by the existence of the open detection initialization circuit 1, an example without the open detection initialization circuit 1 is explained first. Fig. 11 illustrates an A/D converter 200 without the open detection initialization circuit 1. Note that since other circuit configuration is the same as Fig. 2, the explanation is omitted.

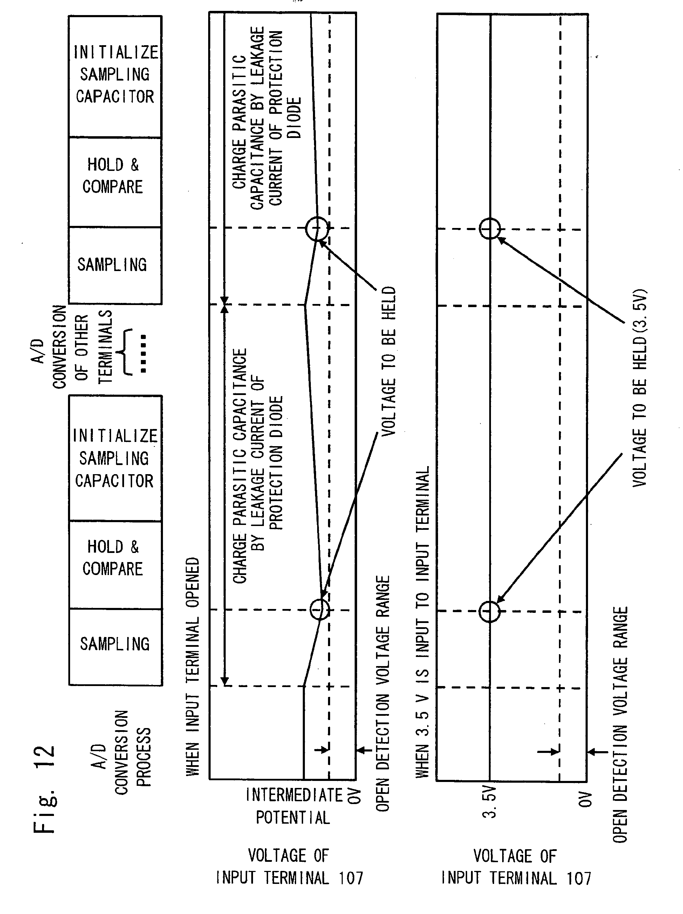

Fig. 12 is a timing chart of the circuit shown in Fig. 11. The top column of Fig. 12 illustrates operations of the A/D conversion process, the middle column is a timing chart of the voltage value of the external input terminal 107 at the time of input terminal opened, and the bottom column is a timing chart at the time of normal operation (an example when the power supply voltage is 3.5 V is illustrated). In the example of Fig. 12, the A/D conversion process is performed to the signal from the external input terminal 107 which is selectively specified by the selector 103, in the order of sampling, hold and comparison, and initialization of the sampling capacitor 104. Then, similar A/D conversion process is performed also to the signal from different external input terminal 107 which is selectively specified by the selector 103. In this way, the A/D conversion process is repeatedly performed to the signal from the external input terminal 107 selectively specified by the selector 103.

First, in the example of the normal operation illustrated in Fig. 12, the voltage of the external input terminal 107 indicates a fixed value at any time, and normal A/D conversion process is performed. On the other hand, in the example of the input terminal opened, at the time of sampling, the charge of the external input terminal 107 indicating an undefined voltage value (hereinafter referred to as an intermediate potential) is discharged to the sampling capacitor 104, and the voltage of the external input terminal 107 decreases. However, since the voltage of the external input terminal 107 at the time of the input terminal opened is undefined, it is not guaranteed that the voltage of the external input terminal 107 decreases down to the open detection voltage range. Thus accurate open detection cannot be performed.

After that, while the A/D conversion process is performed in the order of hold and comparison, initialization of the sampling capacitor, and similar operation to other external input terminals 107, the voltage of the first external input terminal 107 increases again by the influence of the leakage current flowing from the corresponding protection diode 101. This is because that charges are accumulated in the parasitic capacitance of the selector 103 or the like by the influence of the leakage current flowing from the protection diode 101. Therefore, even if the A/D conversion process is performed again to the first external input terminal 107, there is a possibility that the voltage of the external input terminal 107 does not decrease down to the open detection voltage range at the time of sampling. In Fig. 12, as indicated by the circles, the voltage is held over the open detection voltage range. Thus, there is a possibility that the open detection may not be performed even if the A/D conversion process is repeatedly performed.

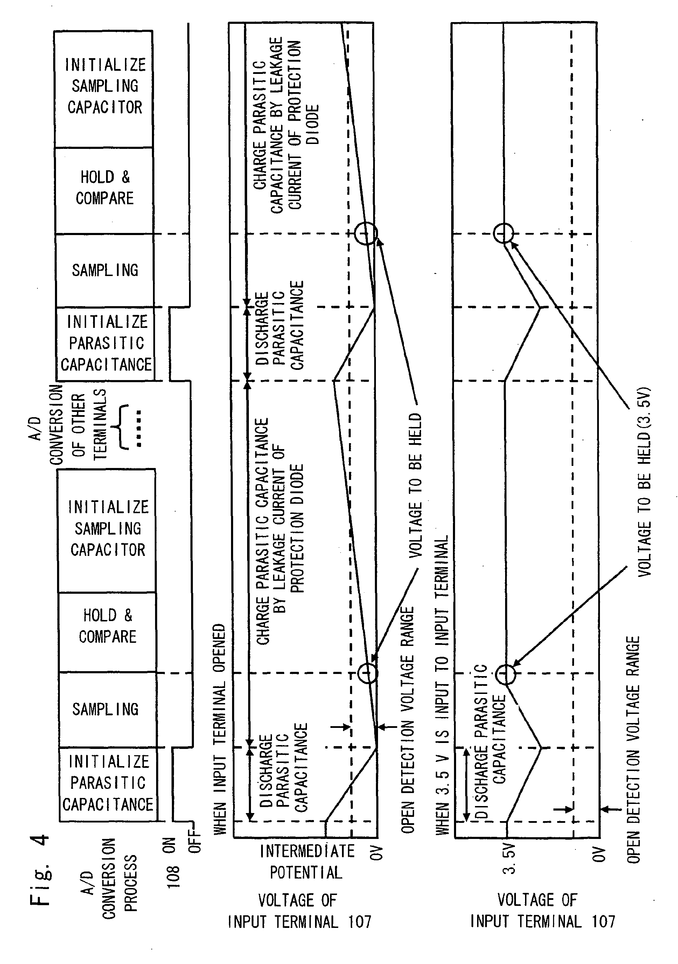

Next, Fig. 4 is a timing chart of an A/D converter 100 including the open detection initialization circuit 1. In the example of Fig. 4, the A/D conversion process is performed to the analog signal from the external input terminal 107 which is selectively specified by the selector 103 in the order of initialization of parasitic capacitance, sampling, hold and comparison, and initialization of the sampling capacitor. A different point from the related art is that the initialization of the parasitic capacitance is performed before sampling. Note that in the initialization of the parasitic capacitance, by turning on the connection state of the parasitic capacitance initialization switch 108, the charges accumulated in the parasitic capacitance on the input node, which connects the external input terminal 107 and the selector circuit 103, is initialized (discharged). Then, similar A/D conversion process is performed also to the signal from different external input terminal 107 which is selectively specified by the selector 103. In this way, the A/D conversion process is repeatedly performed to the signal from the external input terminal 107 selectively specified by the selector 103.

First, in the example of the normal operation shown in Fig. 4 (bottom column of Fig. 4), the connection state of the parasitic capacitance initialization switch 108 is turned on when initializing the parasitic capacitance. Then the input node, which connects the external input terminal 107 and the selector circuit 103, is connected to a ground voltage terminal, and the voltage of the external input terminal 107 decreases. However, by turning off the connection state of the parasitic capacitance initialization switch 108, the voltage of the external input terminal increases again to 3.5 V. Therefore, at the time of the normal operation, even when the parasitic capacitance is initialized, normal A/D conversion process is performed.

On the other hand, in the example of input terminal opened shown in Fig. 4 (middle column of Fig. 4), the charge of the external input terminal 107 indicating the intermediate potential is discharged to the ground voltage terminal. Thus the voltage of the external input terminal 107 decreases to the open detection voltage range. After that, at the time of sampling, by the influence of the leakage current flowing from the protection diode 101, charges are accumulated in the parasitic capacitance of the selector 103 or the like, and the voltage of the external input terminal 107 increases again. However, since the voltage of the external input terminal 107 is sufficiently reduced by the initialization of the parasitic capacitance, it is possible to maintain the open detection voltage range at the time of sampling. Therefore, accurate open detection can be performed.

As described so far, when performing the A/D conversion process to the analog signal from the external input terminal 107, the A/D converter 100 according to this exemplary embodiment can initialize (discharge) the charges accumulated in the parasitic capacitance on the input node, which connects the external input terminal 107 and the selector circuit 103, by turning on the connection state of the parasitic capacitance initialization switch 108 disposed in the open detection initialization circuit 1. Accordingly, the influence of the leakage current by the protection diode or the like can be substantially eliminated, and thereby enabling accurate open detection.

Note that as another solution to reduce the influence of the leakage current of the protection diode 101, there is a method in which a leakage current amount of the protection diode disposed on the ground voltage terminal side and a leakage current amount of the protection diode disposed on the power supply voltage terminal side are equalized. The A/D converter 100 according to this exemplary embodiment can realize open detection with low cost and high accuracy than the above method.

### [Second exemplary embodiment]

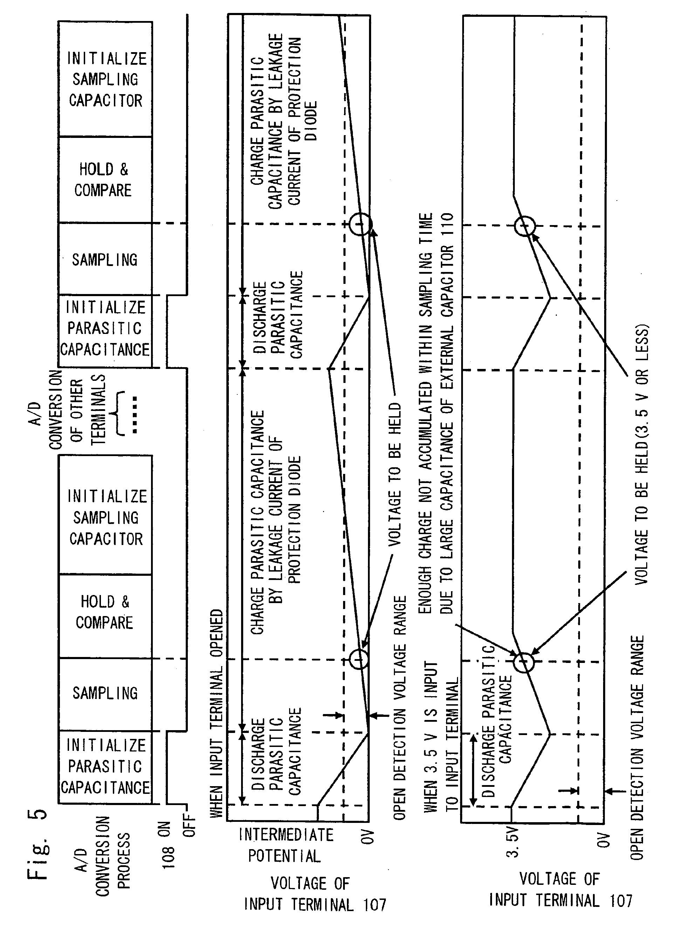

For the circuit shown in Fig. 2, Fig. 5 is a timing chart of the A/D converter 100 when the capacitance of an external capacitor 110 connected to the external input terminal 107 is large. In the example of the normal operation shown in Fig. 5 (bottom column of Fig. 5), since the capacitance of the external capacitor 110 is large, if the sampling process is performed after initialization of the parasitic capacitance, sufficient charges cannot be accumulated in the sampling capacitor 104 within the sampling time. Therefore, accurate A/D conversion process may not be performed. A second exemplary embodiment is suggested as a solution for that.

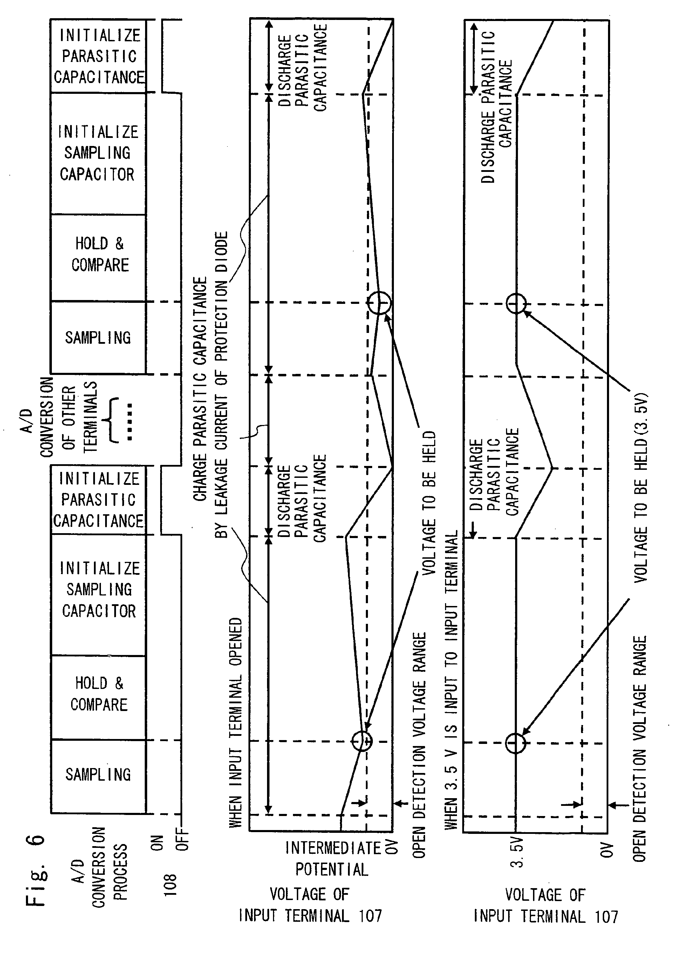

Fig. 6 is a timing chart of an A/D converter 100 according to the second exemplary embodiment. In Fig. 6, the order of the A/D conversion process is changed from the timing chart of Fig. 5. The circuit configuration of the A/D converter 100 is same as the first exemplary embodiment, thus the explanation is omitted.

As shown in Fig. 6, in the second exemplary embodiment of the present invention, A/D conversion process for another external input terminal 107 is performed between initialization of the parasitic capacitance and sampling in the A/D conversion process of a certain external input terminal 107. Therefore, even when initializing the parasitic capacitance in the normal operation, sufficient charges can be accumulated in the sampling capacitor 104 within the sampling time, and accurate A/D conversion process is performed. In this way, the parasitic capacitance initialization switch 108 can switch the connection state at an arbitrary timing according to the control signal output from the control unit 6. Note that in this case, it is necessary to configure the voltage value of the external input terminal 107 to remain in the open detection voltage range within the sampling time at the time of the input terminal opened. In this case, in order to perform A/D conversion process with higher accuracy, the A/D conversion process according to the first exemplary embodiment of the present invention as shown in Fig. 4 is effective.

### [Third exemplary embodiment]

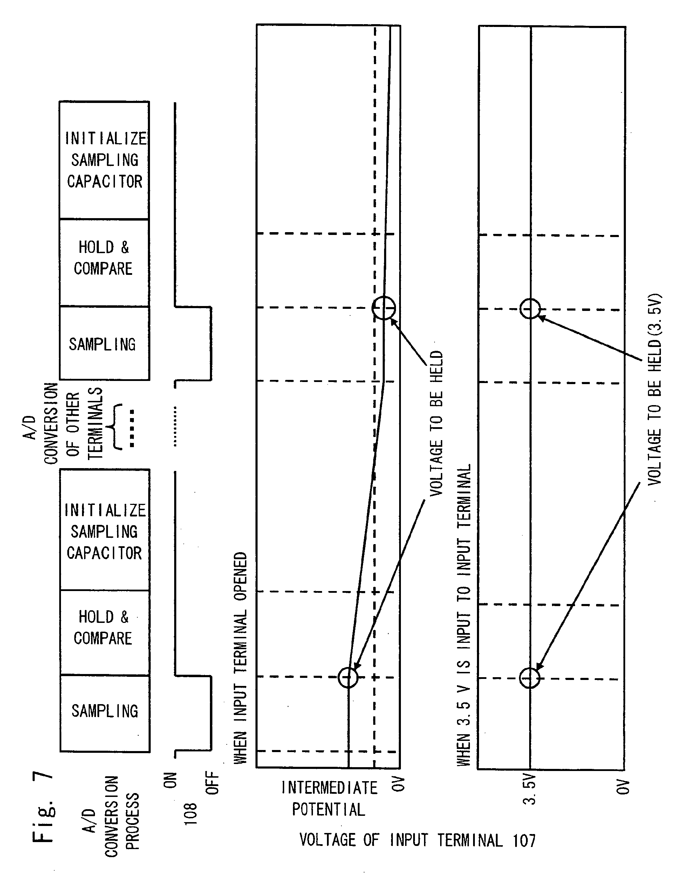

A third exemplary embodiment is described with reference to Fig. 7. In this exemplary embodiment, although a circuit configuration is the same as the first and the second exemplary embodiments, the control timing of the parasitic capacitance initialization switch 108 by the control unit 6 is different. If the resistive element 109 connected to the parasitic capacitance initialization switch 108 has a low resistance, the initialization of the parasitic capacitance can be performed at high speed. However, with a low resistance, the current amount flowing to the resistive element 109 increases, and thereby possibly generating an error in the original A/D conversion result. Therefore, in this exemplary embodiment, even in the case that the resistive element 109 has a high resistance, the influence of the parasitic capacitance is eliminated to enable open detection.

As shown in Fig. 7, the parasitic capacitance initialization switch 108 is controlled to be off during the sampling period and on in the other periods. Fig. 7 explains the operation by this control. First, in the first sampling period, the parasitic capacitance initialization switch 108 is turned off. Thus the voltage supplied to the input terminal 107 is sampled as it is. Specifically, when open failure is generated in the input terminal 107, the intermediate potential is sampled, whereas if normal, 3.5 V is sampled. At this time, no abnormal evaluation is performed to the input terminal 107. After the sampling is completed, the parasitic capacitance initialization switch 108 is turned on, and then the parasitic capacitance initialization switch 108 is kept on while comparison, initialization of the sampling capacitor, and A/D conversion of other terminals. Since the resistive element 109 has a high resistance, when the input terminal 107 is normal, the input potential hardly changes.

On the other hand, when the input terminal 107 has open failure, the voltage continues to decrease. Then in the second sampling period, the parasitic capacitance initialization switch 108 is turned off in a similar manner. When open failure is generated in the input terminal 107, as a result of the continued reduction in the potential, the potential to be sampled will be within the open detection voltage range. Whereas if normal, the potential to be sampled will be 3.5 V, which is an input potential. Therefore, by performing abnormal evaluation to the input terminal 107 at this time, the open failure can be detected. This exemplary embodiment has an exemplary advantage that the sequence of "initialization of parasitic capacitance" can be omitted as compared to the first and the second exemplary embodiments.

### [Fourth exemplary embodiment]

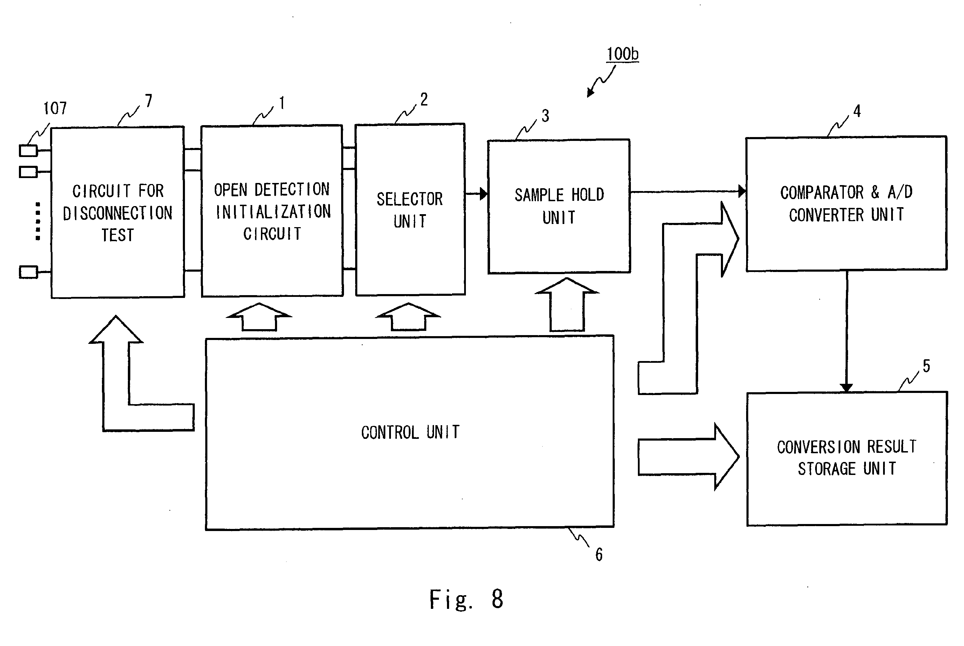

A fourth exemplary embodiment is described with reference to Fig. 8. Fig. 8 illustrates an A/D converter 100b that further includes a circuit for disconnection test 7 in addition to the configuration of Fig. 1. Specifically, the A/D converter 100b includes the circuit for disconnection test 7 disposed between the external input terminals 107 and the open detection initialization circuit 1. Further, the resistive element 109 of Fig. 2 be shall be a variable resistor (not shown). The resistance of the resistive element 109 is determined by control from the control unit 6. The configuration of the variable resistor may be a known art, for example the one composed of a plurality of resistive elements and switches.

The resistance of the resistive element 109 of Fig. 2 influences the speed and the A/D conversion result of initialization of the parasitic capacitance as already explained earlier. To be specific, with a high resistance, the initialization of the parasitic capacitance becomes slow, whereas with a low resistance, the initialization of the parasitic capacitance becomes fast. Accordingly, a low resistance is effective if only the initialization speed of the parasitic capacitance is considered. However in this case, an error can be easily generated in the A/D conversion, which is an original operation. Similarly for the parasitic capacitance initialization switch 108, if on time is increased, the initialization of the parasitic capacitance becomes faster, whereas the time required for A/D conversion increases. If the on time is shortened, it takes time to initialize the parasitic capacitance, however the time required for one A/D conversion becomes short.

Therefore, the resistance of the resistive element 109 and the on time of the parasitic capacitance initialization switch 108 must be adjusted according to actual usage situation. Then, in this exemplary embodiment, by specifying the virtual disconnection state, making the resistive element 109 a variable resistor, and making the on time of the parasitic capacitance initialization switch 109 be variable, the A/D converter of the present invention can be applied depending on the actual usage status.

The operation is explained hereinafter. First, the disconnection state of the input terminal is specified by the circuit for disconnection test 7. The circuit for disconnection test 7 may be a switch. By turning off the circuit for disconnection test 7, the virtual disconnection state can be specified. The control unit 6 performs detection of the disconnection state and the A/D conversion while changing the resistance of the resistive element 109 and the on time of the parasitic capacitance initialization switch 108, and stores the resistance when an expected A/D conversion result is obtained and the on time when the open failure of the input terminal is detected within expected time.

After completing the disconnection test, the resistance of the resistive element 109 and the on time of the parasitic capacitance initialization switch 108 are determined according to the stored information, and the operations according to the first to the third exemplary embodiment are performed.

Note that the present invention is not limited to the above exemplary embodiments, and may be modified without departing from the scope of the present invention. For example, in this exemplary embodiment, an example is explained in which the charges are accumulated in the parasitic capacitance by the leakage current flowing from the protection diode. However, it is not limited to this, and the present invention can be applied in a similar manner to a case when the charges are accumulated by other leakage current sources.

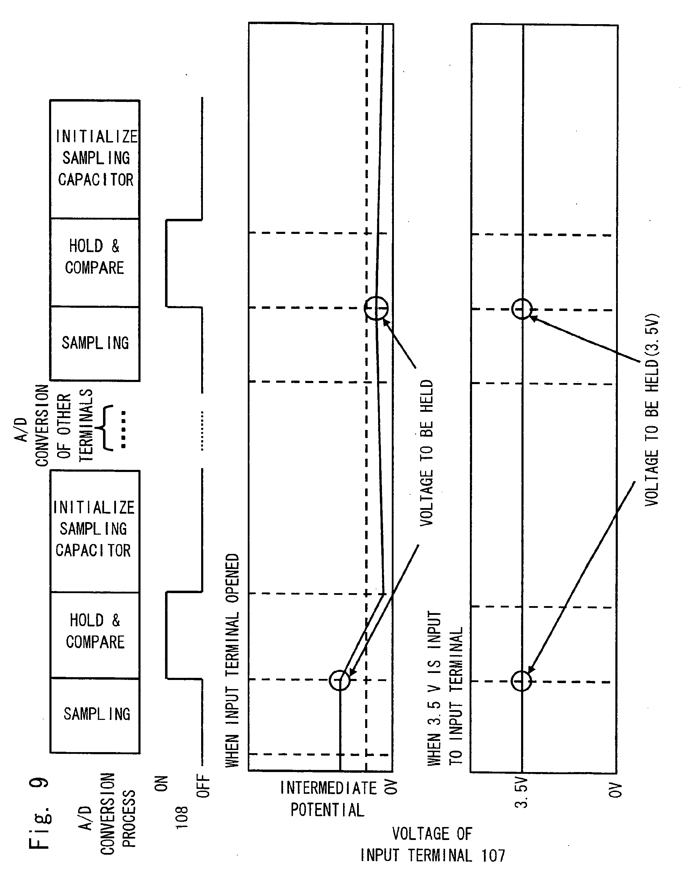

Each operation in the A/D conversion process can be performed at an arbitrary operation timing. As an example, there may be a sequence that turns on the parasitic capacitance initialization switch 108 in the time zone not performing the A/D conversion, for example, the time zone while resetting (initializing) the circuit, and the time zone while performing the A/D conversion to other input terminals. Further, as another example, the control of the parasitic capacitance initialization switch 108 can be performed as in Fig. 9. In Fig. 9, the parasitic capacitance initialization switch 108 is turned on only in the hold and comparison period. In the case of Fig. 9, the potential of the input terminal 107 is sampled as it is in the first sampling, thus the abnormal evaluation is not performed to the input terminal 107 at this time. The abnormal evaluation is performed at the next sampling. Alternatively, the parasitic capacitance initialization switch 108 may be turned on in the initialization of the sampling capacitor instead of the hold and comparison period. In these cases, there is no need to have the sequence "initialization of the parasitic capacitance" as in Fig. 4.

Further, in this exemplary embodiment, an example in which there are a plurality of external input terminals 107 is explained, however it is not limited to this, and the exemplary embodiment can be applied to the case in which there is only one external input terminal 107. Note that in that case, since it is not necessary to select a signal from the external input terminal 107, the selector 103 is unnecessary.

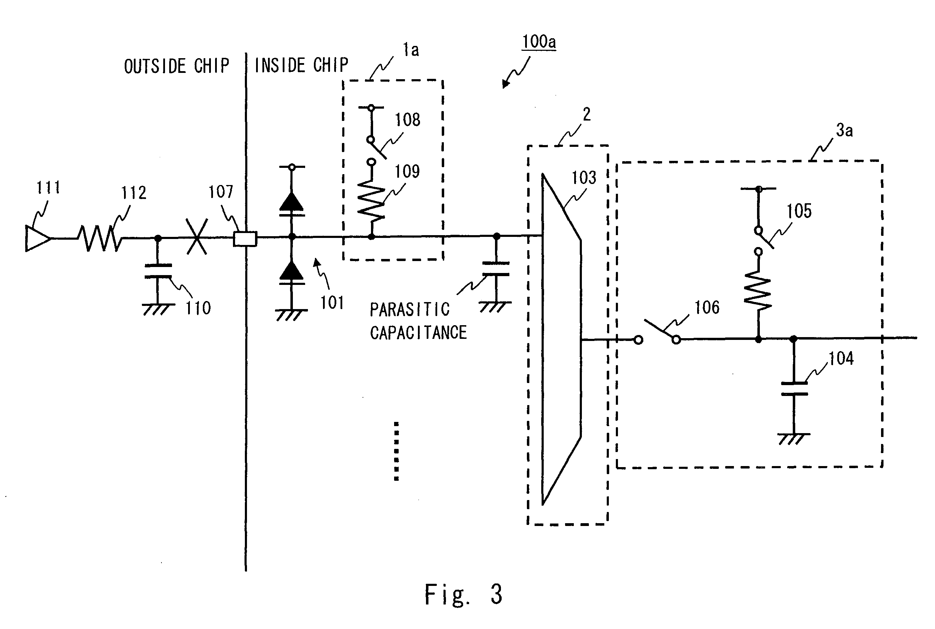

Moreover, in this exemplary embodiment, a case is explained in which one end of the parasitic capacitance initialization switch 108 included in the open detection initialization circuit 1 is connected to a ground voltage terminal. However it is not limited to this, and the exemplary embodiment can be applied to the case in which one end of the parasitic capacitance initialization switch 108 is connected to the power supply voltage terminal. As a specific example, Fig. 3 illustrates an A/D converter 100a, which is a modification of the A/D converter 100 of Fig. 2. The differences of the A/D converter 100a from the A/D converter 100 of Fig. 2 are that an initialization switch 105 of a sampling capacitor 3a is connected to a power supply voltage terminal, and an open detection initialization circuit 1a is connected to the power supply voltage terminal side. Other circuit configuration is same as Fig. 2, thus the explanation is omitted. In the open detection initialization circuit 1a, an input node, which connects the external input terminal 107 and the selector 103, and the power supply voltage terminal are connected via the resistive element 109 and the parasitic capacitance initialization switch 108. Then the charges accumulated in the parasitic capacitance on the input node, which connects the external input terminal 107 and the selector circuit 103, can be initialized (charged).

Note that in this case, a voltage value output from the initialized sampling capacitor 104 shall be an upper reference voltage (VREF+) of the reference voltage, i.e., a value equivalent to 100% of the reference voltage. Further, the open detection voltage range shall be a value equivalent to 90% or more of the reference voltage, for example. At this time, if an anomaly such as a disconnection is generated between an analog signal source and the external input terminal 107 or between the external input terminal 107 and the sampling capacitor 104, as the sampling capacitor 104 remains in the initialized state in the subsequent sampling operation, the anomaly is determined to be an anomaly in the input system. Therefore, it is possible to perform open detection of the A/D converter by this configuration.

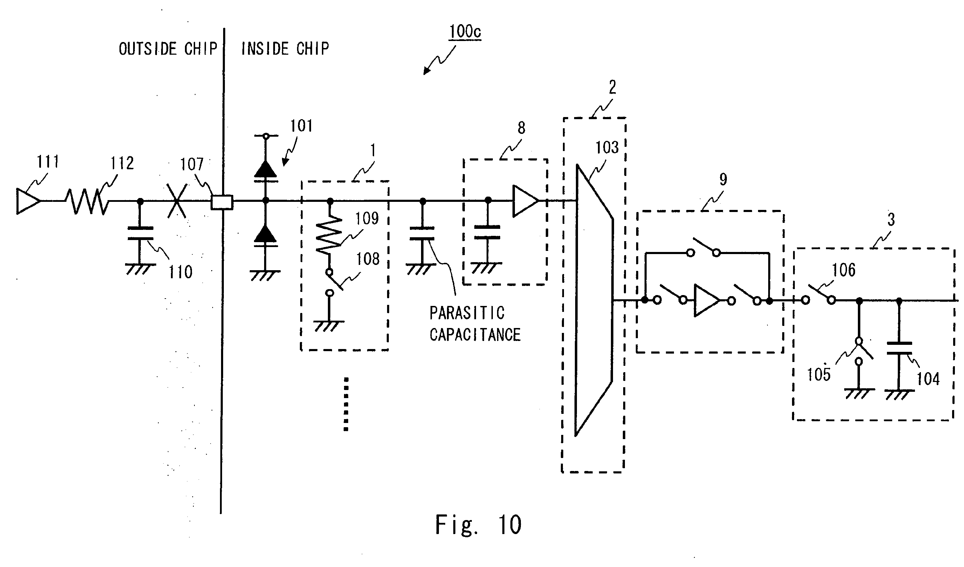

Moreover, the configuration as in Fig. 10 can also be possible. An A/D converter 100c illustrated in Fig. 1 further includes a channel sample hold circuit 8 before the selector 103 and a buffer amplifier 9 after the selector 103, in addition to the A/D converter 100 of Fig. 2. Since both are known art, the details are omitted. Both techniques have an exemplary advantage of speeding up the charge (or discharge) time of the sampling capacitor 104. In the present invention, even if the channel sample hold circuit 8 and the buffer amplifier 9 are added, the open detection initialization circuit 1 initializes the potential to a ground potential even when a failure of the input terminal opened is generated, the above exemplary advantage can be maintained.

The first to fourth exemplary embodiments can be combined as desirable by one of ordinary skill in the art.

While the invention has been described in terms of several exemplary embodiments, those skilled in the art will recognize that the invention can be practiced with various modifications within the spirit and scope of the appended claims and the invention is not limited to the examples described above.

Further, the scope of the claims is not limited by the exemplary embodiments described above.

Furthermore, it is noted that, Applicant's intent is to encompass equivalents of all claim elements, even if amended later during prosecution.

## Claims

1. An A/D converter comprising:
a sampling capacitor that accumulates a charge according to an input voltage;
a first initialization switch that initializes the sampling capacitor;
a sample hold switch that switches a connection state of an external input terminal and the sampling capacitor; and
a second initialization switch that initializes a charge accumulated in an input node via a resistor, the input node connecting the external input terminal and the sample hold switch.

2. The A/D converter according to Claim 1, wherein the second initialization switch is disposed between the input node and a ground voltage terminal.

3. The A/D converter according to Claim 1, wherein the second initialization switch is disposed between the input node and a power supply voltage terminal.

4. The A/D converter according to any one of Claims 1 to 3, further comprising a selector circuit that is connected between a plurality of the external input terminals and the sample hold switch and selectively outputs one of signals from the plurality of external input terminals,
wherein each second initialization switch is disposed for each input node that connects the external input terminal and the selector circuit.

5. The A/D converter according to any one of Claim 1 to 3, further comprising a control unit that outputs a first control signal, a second control signal, and a third control signal, the first control signal controlling a connection state of the first initialization switch, the second control signal controlling the connection state of the second initialization switch, and the third control signal controlling the connection state of the sample hold switch;
wherein the first to the third control signals are independently controlled.

6. The A/D converter according to Claim 4, further comprising a control unit that outputs a first control signal, a second control signal, a third control signal, and a fourth control signal, the first control signal controlling a connection state of the first initialization switch, the second control signal controlling the connection state of the second initialization switch, the third control signal controlling the connection state of the sample hold switch, and the fourth control signal controlling an output signal of the selector circuit;
wherein the first to the fourth control signals are independently controlled.

7. The A/D converter according to any one of Claim 1 to 6, further comprising a protection diode, one terminal of the protection diode being connected to the input node.

8. An open detection method of an A/D converter including a sampling capacitor and a switch connected between the sampling capacitor and an input terminal, the open detection method comprising:
initializing a parasitic capacitance that is formed in wiring between the input terminal and the switch;
after the initialization, connecting the sampling capacitor to the input terminal by the switch and sampling an input voltage; and
detecting open failure according to a sampling result of the sampling capacitor.

9. The open detection method according to Claim 8, further comprising after predetermined time from the initialization of the parasitic capacitance, connecting the sampling capacitor to the input terminal by the switch and sampling an input voltage.
